# EUROPÄISCHE PATENTSCHRIFT

(11) **EP 1 886 347 B1**
(45) Veröffentlichungstag und Bekanntmachung des Hinweises auf die Patenterteilung: **24.02.2010**
(21) Anmeldenummer: 06753689.6
(22) Anmeldetag: 17.05.2006
(51) Int. Cl.: H01L 27/148, H01L 27/146

(54) **STRAHLUNGSDETEKTOR ZUR DETEKTION INTENSITÄTSARMER STRAHLUNG MITTELS LAWINENVERSTÄRKUNG SOWIE SEIN BETRIEBSVERFAHREN**
RADIATION DETECTOR FOR DETECTING LOW-INTENSITY RADIATION BY MEANS OF AVALANCHE AMPLIFICATION AND METHOD OF ITS OPERATION
DETECTEUR DE RAYONNEMENT POUR DETECTER UN RAYONNEMENT DE FAIBLE INTENSITE PAR AMPLIFICATION D'AVALANCHE ET SON PROCEDE DE FONCTIONNEMENT

(30) Priorität: 03.06.2005 DE 102005025641
(43) Veröffentlichungstag der Anmeldung: 13.02.2008
(73) Patentinhaber: Max-Planck-Gesellschaft zur Förderung der Wissenschaften e.V., 80539 München (DE)
(72) Erfinder: LUTZ, Gerhard, 81739 München (DE); STRUEDER, Lothar, 80803 München (DE); HOLL, Peter, 80803 München (DE)
(74) Vertreter: Beier, Ralph
(86) Internationale Anmeldenummer: PCT/EP2006/004687
(87) Internationale Veröffentlichungsnummer: WO 2006/128588

(56) Entgegenhaltungen:
- EP-A- 0 866 501
- EP-A- 1 152 469
- EP-A- 1 596 439
- US-A- 5 291 294
- US-A1- 2003 042 400
- LUTZ G ET AL: "The avalanche drift diode: a new detector concept for single photon detection" NUCLEAR SCIENCE SYMPOSIUM CONFERENCE RECORD, 2004 IEEE ROME, ITALY 16-22 OCT. 2004, PISCATAWAY, NJ, USA,IEEE, 16. Oktober 2004 (2004-10-16), Seiten 21-24, XP010818787 ISBN: 0-7803-8700-7

## Beschreibung

Die Erfindung betrifft einen Strahlungsdetektor zur Detektion intensitätsarmer Strahlung, insbesondere zur Detektion von Einzelphotonen, sowie ein zugehöriges Betriebsverfahren.

Aus LUTZ, Gerhard: "Semiconductor radiation detectors", Springer Verlag, 2. Auflage 2001, Seite 137-152, sind CCD-Detektoren (CCD - Charge Coupled Devices) bekannt, die zur Strahlungsdetektion verwendet werden. Diese bekannten CCD-Detektoren weisen mehrere parallele Bildzellenreihen mit jeweils mehreren hintereinander angeordneten Bildzellen auf, in denen die zu detektierende Strahlung Signalelektronen generiert. Diese Signalelektronen werden zunächst in Potentialtöpfen gehalten, die im Bereich der einzelnen Bildzellen von einer Elektrodenanordnung erzeugt werden. Durch eine geeignete elektrische Ansteuerung der Elektrodenanordnung werden die Signalelektronen entlang den Bildzellenreihen von Bildzelle zu Bildzelle weitertransportiert und gelangen in den einzelnen Bildzellenreihen jeweils zu einem Signalausgang, an den ein Ausgangsverstärker angeschlossen ist, der das Ausgangssignal verstärkt, damit auch intensitätsarme Strahlung detektiert werden kann. Bei den bekannten CCD-Detektoren besteht der Ausgangsverstärker beispielsweise aus einem einfachen Transistor, der zusammen mit dem CCD-Detektor auf einem Halbleitersubstrat integriert ist.

Nachteilig an den vorstehend beschriebenen bekannten CCD-Detektoren ist jedoch die unbefriedigende Empfindlichkeit, die nicht zur Detektion von Einzelphotonen, mit Energien von weniger als 30 eV ausreicht.

Aus HOLLAND, A.D.: "New developments in CCD and pixel arrays", Nuclear Instruments and methods in Physics research A. Vol. 513 (2003), 308-312 und aus der dort erwähnten Druckschrift JERRAM et al.: "The LLLCCD: Low Light Imaging without the need for an intensifier", Proceedings of SPIE Vol. 4306 (2001), 178-186 ist zwar eine CCD-Struktur mit einem Avalanche-Verstärker als Ausgangsverstärker bekannt. Bei diesem Stand der Technik münden die einzelnen Bildzellenreihen der CCD-Struktur jedoch in ein gemeinsames Schieberegister, das die Signalelektronen seriell in ein weiteres Schieberegister schiebt, in dem eine mehrstufige Avalanche-Verstärkung erfolgt.

Diese bekannten Detektor-Strukturen mit einer mehrstufigen, seriellen Avalanche-Verstärkung weisen jedoch verschiedene Nachteile auf. So führt das serielle Auslesen der Signalelektronen hierbei zu einer geringen Auslesegeschwindigkeit und zu einer entsprechend geringen Bildwiederholrate. Darüber hinaus erfolgt die Avalanche-Verstärkung hierbei mehrstufig, was zu einer hohen Nichtlinearität führt.

Darüber hinaus ist aus HYNECEK, J.: "CCM - A new low-noise charge carrier multiplier suitable for detection of charge in small pixel CCD image sensors", IEEE Transactions on Electron Devices, Vol. 39, No. 8 (1992), 1972-1975 eine CCD-Detektorstruktur bekannt, bei der eine Verstärkung der Signalelektronen erfolgt. Die Verstärkung erfolgt hierbei jedoch innerhalb der CCD-Detektorstruktur und nicht in einem separaten Ausgangsverstärker. Darüber hinaus erfolgt die Verstärkung hierbei nicht einstufig, sondern mehrstufig mit jeweils einem sehr kleinen Verstärkungsfaktor. Nachteilig an dieser mehrstufigen Verstärkung ist jedoch die Tatsache, dass zwischen dem Einfall der zu detektierenden Strahlung und dem Erscheinen der strahlungsgenerierten Signalladungsträger am Ausgang des Verstärkers eine große Ausleseverögerung (Latenzzeit) liegt. Dies liegt daran, dass die strahlungsgenerierten Signalladungsträger auf ihrem Weg zum Ausgang des Verstärkers die zahlreichen Verstärkungsstufen passieren müssen.

Auch aus EP 0 866 501 A1 ist ein Strahlungsdetektor bekannt, der als Ausgangsverstärker Multiplikationsregister verwendet, wie sie in der vorstehend erwähnten Veröffentlichung "CCM - A new low-noise charge carrier multiplier suitable for detection of charge of small pixle CCD image sensors" beschrieben sind. Auch dieser Strahlungsdetektor weist deshalb eine große Ausleseverzögerung auf, da die strahlungsgenerierten Signalladungsträger auf ihrem Weg zum Ausgang des Multiplikationsregisters die zahlreichen Verstärkungsstufen passieren müssen.

Ferner ist zum Stand der Technik noch hinzuweisen auf EP-A-1 152 469, Lutz et al. "The avalanche drift diode: A new detector concept for single photon detection" Nuclear science symposium conference record, 2004 IEEE Rome, Italy 16-22 October 2004, Piscataway, NJ, USA, IEEE, 16. Oktober 2004, Seiten 21-24, XP010818787 ISBN: 0-7803-8700-7 und US-A-5 291 294.

Ferner sind US2005/0083567A1 und WO02/37139A1 Detektoranordnungen bekannt, die jedoch weniger einschlägig sind.

Der Erfindung liegt deshalb die Aufgabe zugrunde, bei dem vorstehend beschriebenen bekannten CCD-Detektor die Empfindlichkeit zu verbessern.

Diese Aufgabe wird durch einen erfindungsgemäßen Strahlungsdetektor gemäß Anspruch 1 und ein entsprechendes Betriebsverfahren gemäß Anspruch 16 gelöst.

Die Erfindung umfasst die allgemeine technische Lehre, zur Verstärkung des Ausgangssignals der einzelnen Bildzellenreihen der CCD-Struktur mehrere parallele Avalanche-Verstärker einzusetzen.

Die Verwendung eines Avalanche-Verstärkers bietet den Vorteil, dass die an den Signalausgängen der einzelnen Bildzellenreihen ausgelesenen Signalladungsträger auch bei der Detektion von Einzelphotonen weit über das Rauschen der Ausleseelektronik verstärkt werden.

Der erfindungsgemäße Strahlungsdetektor ermöglicht also im Gegensatz zu den bekannten Strahlungsdetektoren auch die Detektion von Einzelphotonen mit Energien von weniger als 30 eV. Die Erfindung ist jedoch nicht auf Strahlungsdetektoren beschränkt, die eine derartig hohe Empfindlichkeit aufweisen. Vielmehr umfasst die Erfindung auch Strahlungsdetektoren mit einer geringeren Empfindlichkeit, die beispielsweise nur Einzelphotonen mit einer Energie von mehr als 30 eV detektieren können.

Die parallele Anordnung der einzelnen Avalanche-Verstärker an den Signalausgängen der einzelnen Bildzellenreihen bietet den Vorteil, dass eine hohe Bildwiederholrate möglich ist. Beispielsweise kann der erfindungsgemäße Strahlungsdetektor eine Bildwiederholrate von mindestens 100, 500 oder 1000 Bildern pro Sekunde aufweisen.

Erfindungsgemäß weisen die einzelnen Avalanche-Verstärker jeweils einen einzigen Avalanche-Bereich (Hochfeld-Bereich) auf, in dem die Avalanche-Verstärkung erfolgt. Bei der Erfindung erfolgt die Avalanche-Verstärkung also einstufig und nicht mehrstufig, wie bei den eingangs erwähnten Veröffentlichungen von HOLLAND und JERRAM.

Darüber hinaus ist der Avalanche-Bereich bei der Erfindung von den Bildzellen räumlich getrennt, wohingegen die Avalanche-Verstärkung bei der eingangs erwähnten bekannten Veröffentlichung von HYNECEK innerhalb der Detektorstruktur erfolgt.

In einem bevorzugten Ausführungsbeispiel der Erfindung weist der Strahlungsdetektor zur Strahlungsdetektion eine CCD-Detektorstruktur auf, wie sie in Gerhard Lutz: "Semiconductor radiation detectors", Springer Verlag, 2. Auflage 2001, Seite 137-152, beschrieben ist, so dass der Inhalt dieser Veröffentlichung der vorliegenden Beschreibung hinsichtlich des Aufbaus und der Funktionsweise der CCD-Detektorstruktur in vollem Umfang zuzurechnen ist. Beispielsweise kann die CCD-Detektorstruktur eine pn-CCD-Detektorstruktur oder eine MOSCCD-Detektorstruktur sein, wie sie in der vorstehend erwähnten Veröffentlichung beschrieben ist. Die Kombination des erfindungsgemäßen Avalanche-Verstärkers mit einer pn-CCD-Detektorstruktur ist jedoch besonders vorteilhaft, da die Signalladungsträger in einer pn-CCD-Detektorstruktur in einer Tiefe von ungefähr 2-15 µm gespeichert und entlang den Bildzellenreihen weiter transportiert werden, so dass die Signalladungsträger dann in einem vertikal ausgerichteten Avalanche-Verstärker wieder an die Oberfläche der Halbleiterstruktur zu einer dort befindlichen Ausleseelektrode beschleunigt werden können.

Die Erfindung ist jedoch hinsichtlich der zur Strahlungsdetektion dienenden Bildzellen nicht auf eine CCD-Detektorstruktur beschränkt, sondern grundsätzlich auch mit anderen Typen von Bildzellen realisierbar, die Signalladungsträger generieren.

Weiterhin ist zu erwähnen, dass in den einzelnen Bildzellen als Signalladungsträger vorzugsweise Signalelektronen genutzt werden. Es ist jedoch grundsätzlich auch möglich, dass in den einzelnen Bildzellen als Signalladungsträger Löcher genutzt werden, die entlang den Bildzellenreihen zu dem Signalausgang transportiert werden.

Vorzugsweise sind die Bildzellen und der Avalanche-Verstärker bei dem erfindungsgemäßen Strahlungsdetektor gemeinsam in einem Halbleitersubstrat integriert. Auf diese Weise kann auf kapazitätsbehaftete Verbindungsleitungen zwischen den Signalausgängen der einzelnen Bildzellenreihen und den zugehörigen Ausgangsverstärkern weitgehend verzichtet werden.

In einem Beispiel weisen die einzelnen Avalanche-Verstärker jeweils einen Avalanche-Bereich mit einer elektrischen Avalanche-Feldstärke auf, die gegenüber der Oberfläche des Halbleitersubstrats angewinkelt ist. In diesem Beispiel werden die Signalladungsträger also in dem Avalanche-Bereich nicht parallel zu der Oberfläche des Halbleitersubstrats beschleunigt, sondern in einem bestimmten Winkel zu der Oberfläche.

Vorzugsweise ist die Avalanche-Feldstärke hierbei im Wesentlichen rechtwinklig zu der Oberfläche des Halbleitersubstrats ausgerichtet. Dies ist insbesondere dann vorteilhaft, wenn zur Strahlungsdetektion eine pn-CCD-Detektorstruktur verwendet wird, in der die Signalladungsträger in einer Tiefe von etwa 2-15 µm gespeichert und weitertransportiert werden, da die Signalladungsträger dann in dem Avalanche-Bereich des Avalanche-Verstärkers senkrecht zu einer an der Oberfläche des Halbleitersubstrats befindlichen Ausleseelektrode beschleunigt werden können. Die Beschleunigung der Signalladungsträger erfolgt also in dem Avalanche-Bereich vorzugsweise in Richtung der Oberfläche des Halbleitersubstrats.

Es ist jedoch grundsätzlich auch möglich, dass die Signalladungsträger in dem Avalanche-Bereich von der Oberfläche des Halbleitersubstrats weg in das Halbleitersubstrat hinein beschleunigt werden. In einem solchen Fall müssen die Signalladungsträger dann aus der Tiefe des Halbleitersubstrats wieder zu einer an der Oberfläche des Halbleitersubstrats angeordneten Ausleseelektrode transportiert werden, was jedoch grundsätzlich möglich ist.

Weiterhin ist zu erwähnen, dass die einzelnen Ausgangsverstärker zusätzlich zu den Avalanche-Verstärkern vorzugsweise jeweils einen Transistor-Verstärker aufweisen, wobei die Avalanche-Verstärker den Transistor-Verstärkern vorzugsweise vorgeschaltet sind. Bei diesen Transistor-Verstärkern kann es sich um herkömmliche MOSFETs (MOSFET - Metal Oxide Semiconductor Field Effect Transistor) oder JFETs (JFET - Junction Field Effect Transistor) handeln. Der Strahlungsdetektor ist jedoch hinsichtlich des Typs der Transistor-Verstärker nicht auf die vorstehend genannten Typen von Transistor-Verstärkern beschränkt, sondern grundsätzlich auch mit anderen Verstärkertypen realisierbar.

Die Kombination von Transistor-Verstärkern mit Avalanche-Verstärkern ermöglicht einen relativ geringen Verstärkungsfaktor der Avalanche-Verstärker im Bereich von etwa 100 bis 1000. Dies bietet den Vorteil, dass die in den Avalanche-Verstärkern ablaufenden Avalanche-Prozesse bei so geringen Verstärkungsfaktoren nur mit einer geringen Wahrscheinlichkeit optische Photonen erzeugen, die in benachbarten Bildzellen fehldetektiert werden, was zu einem Übersprechen zwischen benachbarten Bildzellen führen würde.

Es ist deshalb vorzugsweise vorgesehen, dass der Verstärkungsfaktor der einzelnen Avalanche-Verstärker so gering ist, dass kein Übersprechen zwischen den benachbarten Avalanche-Verstärkern oder zwischen Avalanche-Verstärkern und benachbarten Bildzellen erfolgt. Hierbei ist zu berücksichtigen, dass sich ein solches Übersprechen aus statistischen Gründen nie vollständig verhindern lässt, da die in den Avalanche-Verstärkern gelegentlich generierten optischen Photonen stets mit einer statistischen Wahrscheinlichkeit fehldetektiert werden. Es kann jedoch davon ausgegangen werden, dass praktisch kein Übersprechen erfolgt, wenn die Fehldetektionsquote, also das Verhältnis von korrekt detektierten Photonen zu fehldetektierten Photonen, größer als 10², 10⁴ oder 10⁶ ist. Vorzugsweise beträgt der Verstärkungsfaktor der einzelnen Avalanche-Verstärker deshalb maximal 500, 1000, 5000 oder 10000.

In einem bevorzugten Ausführungsbeispiel der Erfindung ist weiterhin vorgesehen, dass der Verstärkungsfaktor der Ausgangsverstärker, d.h. der Transistor-Verstärker und/oder der Avalanche-Verstärker, einstellbar ist. Dies bietet den Vorteil, dass der Verstärkungsfaktor an die Intensität der zu detektierenden Strahlung angepasst werden kann. Bei einer relativ großen Strahlungsintensität der zu detektierenden Strahlung können die Avalanche-Verstärker praktisch ausgeschaltet werden, so dass sie einen Verstärkungsfaktor von k=1 aufweisen. Diese Abschaltung der Avalanche-Verstärker bei einer Detektion intensitätsstarker Strahlung ist sinnvoll, da dann der Verstärkungsfaktor der zusätzlichen Transistor-Verstärker ausreicht, um ein verwertbares Ausgangssignal zu erzeugen, während ein Übersprechen von den einzelnen Avalanche-Verstärkern dann ausgeschlossen ist. Bei einer Detektion intensitätsarmer Strahlung können die Avalanche-Verstärker dann mit einem Verstärkungsfaktor k>>1 zugeschaltet werden, damit im Extremfall auch Einzelphotonen detektiert werden können.

Weiterhin ist zu erwähnen, dass die Ausgangsverstärker, d.h. die Transistor-Verstärker und/oder die Avalanche-Verstärker, vorzugsweise eine im Wesentlichen lineare Verstärkung aufweisen, um Verzerrungen bei der Bilddetektion zu vermeiden.

Darüber hinaus weist der erfindungsgemäße Strahlungsdetektor vorzugsweise eine einstellbare Bildwiederholungsrate auf, was vorteilhaft eine Anpassung an die Intensität der zu detektierenden Strahlung ermöglicht. Bei einer Detektion intensitätsstarker Strahlung kann dann eine relativ hohe Bildwiederholungsrate eingestellt werden, da dann in den einzelnen Bildzellen relativ kurze Integrationszeiträume ausreichen, um genügend Signalladungsträger zu generieren. Bei einer geringeren Intensität der zu detektierenden Strahlung wird dagegen vorzugsweise eine geringere Bildwiederholrate eingestellt, was in den einzelnen Bildzellen zu einer größeren Integrationszeit führt, so dass auch bei einem geringen Photonenstrom eine ausreichende Anzahl an Signalladungsträgern generiert werden kann.

Ferner ist zu erwähnen, dass die Erfindung nicht nur den vorstehend beschriebenen erfindungsgemäßen Strahlungsdetektor umfasst, sondern auch ein entsprechendes Betriebsverfahren, das sich bereits aus der vorstehenden allgemeinen Beschreibung ergibt.

Im Rahmen des erfindungsgemäßen Betriebsverfahrens wird der Verstärkungsfaktor der Avalanche-Verstärker vorzugsweise in Abhängigkeit von Betriebsbedingungen des Strahlungsdetektors eingestellt, wobei es sich bei den Betriebsbedingungen beispielsweise um den Photonenstrom bzw. die Intensität der zu detektierenden Strahlung handelt.

Darüber hinaus wird im Rahmen des erfindungsgemäßen Betriebsverfahrens vorzugsweise auch die Bildwiederholrate in Abhängigkeit von Betriebsbedingungen des Strahlungsdetektors eingestellt, wobei diese Betriebsbedingungen beispielsweise den Photonenstrom bzw. die Intensität der zu detektierenden Strahlung umfassen.

Die Bildwiederholrate wird hierbei vorzugsweise entsprechend einer sägezahnförmigen Kennlinie in Abhängigkeit von dem Photonenstrom eingestellt. Die sägezahnförmige Kennlinie weist vorzugsweise zwei steigende Flanken auf, wobei die Avalanche-Verstärker in der einen Flanke der sägezahnförmigen Kennlinie abgeschaltet sind und einen Verstärkungsfaktor von k=1 aufweisen, während die Avalanche-Verstärker in der anderen steigenden Flanke der sägezahnförmigen Kennlinie angeschaltet sind und einen Verstärkungsfaktor von k>>1 aufweisen.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: ein schematisiertes Schaltbild eines erfindungsgemäßen Strahlungsdetektors mit einer matrixförmigen CCD-Detektorstruktur und einer Ausgangsverstärkereinheit, wobei der Strahlungsdetektor an einen herkömmlichen CAMEX-Verstärker angeschlossen ist,
- Figur 2: eine schematisierte Querschnittsdarstellung entlang einer Bildzellenreihe der CCD-Detektorstruktur gemäß Figur 1 mit einem Avalanche-Verstärker und einem nachgeordneten p-Kanal-MOSFET,
- Figur 3: eine Abwandlung von Figur 2, wobei dem Avalanche-Verstärker ein n-Kanal-SSJFET nachgeschaltet ist,
- Figur 4: eine weitere Abwandlung von Figur 2, bei der der Ausgangsverstärker ein DEPFET mit integrierter Avalanche-Verstärkung ist, sowie
- Figur 5: eine sägezahnförmige Kennlinie zur Festlegung der Bildwiederholrate in Abhängigkeit von der Intensität der zu detektierenden Strahlung.

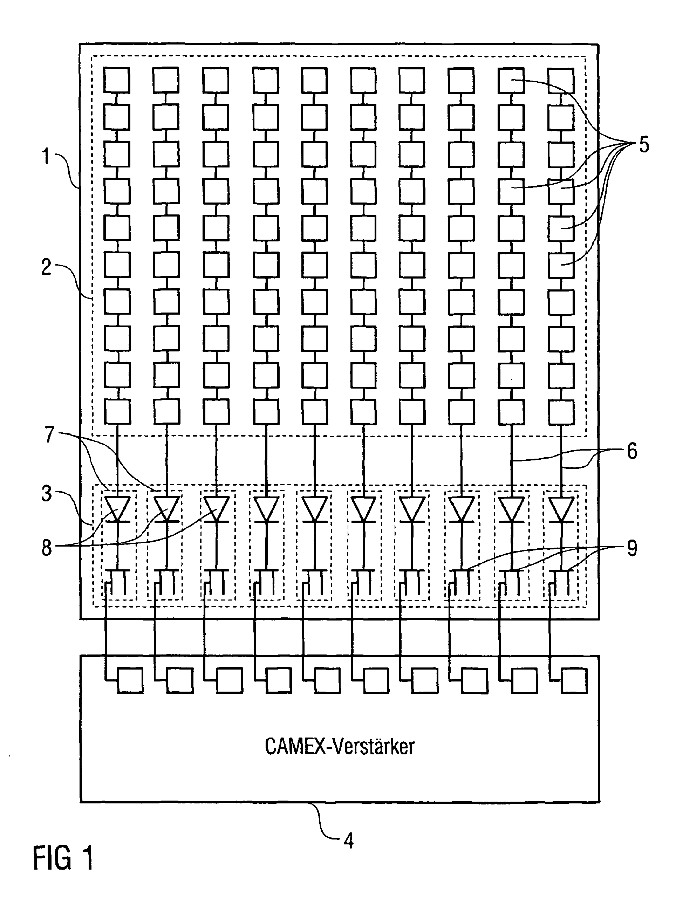

Figur 1 zeigt in schematisierter Form einen erfindungsgemäßen Strahlungsdetektor 1 mit einer herkömmlichen matrixförmigen CCD-Detektorstruktur 2 und einer Ausgangsverstärkereinheit 3, wobei die Ausgangsverstärkereinheit 3 zusammen mit der CCD-Detektorstruktur 2 auf einem gemeinsamen Halbleitersubstrat integriert ist.

Ausgangsseitig ist der Strahlungsdetektor 1 an einen herkömmlichen CAMEX-Verstärker 4 angeschlossen, wie er beispielsweise in Gerhard Lutz: "Semiconductor radiation detectors", Springer Verlag, 2. Auflage 2001, Seite 207-210 beschrieben ist, so dass hinsichtlich des Aufbaus und der Funktionsweise des CAMEX-Verstärkers 4 auf die vorstehende Veröffentlichung verwiesen wird, die der vorliegenden Beschreibung hinsichtlich des CAMEX-Verstärkers 4 in vollem Umfang zuzurechnen ist. Anstelle des CAMEX-Verstärkers 4 kann jedoch auch ein anderer Verstärkertyp eingesetzt werden.

Die CCD-Detektorstruktur 2 ist ebenfalls in herkömmlicher Weise aufgebaut, wie beispielsweise in Gerhard Lutz: "Semiconductor radiation detectors", Springer Verlag, 2. Auflage 2001, Seite 137-152, beschrieben ist. Im Folgenden kann deshalb auf eine detaillierte Beschreibung des Aufbaus und der Funktionsweise der CCD-Detektorstruktur 2 verzichtet werden, da der Inhalt der vorstehend erwähnten Veröffentlichung der vorliegenden Beschreibung hinsichtlich des Aufbaus und der Funktionsweise der CCD-Detektorstruktur 2 in vollem Umfang zuzurechnen ist. Es ist an dieser Stelle lediglich zu erwähnen, dass die CCD-Detektorstruktur 2 mehrere Bildzellenreihen aufweist, in denen jeweils mehrere Bildzellen 5 hintereinander angeordnet sind, wobei die zu detektierende Strahlung in den einzelnen Bildzellen 5 der CCD-Detektorstruktur 2 Signalelektronen generiert, die in den einzelnen Bildzellenreihen zu jeweils einem Signalausgang 6 transportiert werden.

Die Ausgangsverstärkereinheit 3 des Strahlungsdetektors 1 weist mehrere parallele Ausgangsverstärker 7 auf, die parallel an die einzelnen Signalausgänge 6 der einzelnen Bildzellenreihen der CCD-Detektorstruktur 2 angeschlossen sind. Die parallele Anordnung der einzelnen Ausgangsverstärker 7 bietet den Vorteil, dass aufgrund des parallelen Auslesens eine relativ hohe Bildwiederholrate von mehr als 1000 Bildern pro Sekunde möglich ist.

Die einzelnen Ausgangsverstärker 7 weisen jeweils einen Avalanche-Verstärker 8 und einen nachgeschalteten Transistor-Verstärker 9 auf, wobei die Avalanche-Verstärker 8 und die Transistor-Verstärker 9 jeweils einen einstellbaren Verstärkungsfaktor aufweisen und die Detektion von Einzelphotonen ermöglichen.

Der Verstärkungsfaktor der einzelnen Avalanche-Verstärker 8 liegt hierbei im eingeschalteten Zustand im Bereich von 100-1000, wobei derartige Verstärkungsfaktoren gering genug sind, um zu verhindern, dass die in den Avalanche-Verstärkern 8 aufgrund der Lawinenverstärkung entstehenden optischen Photonen zu einem Übersprechen in benachbarte Bildzellenreihen führen.

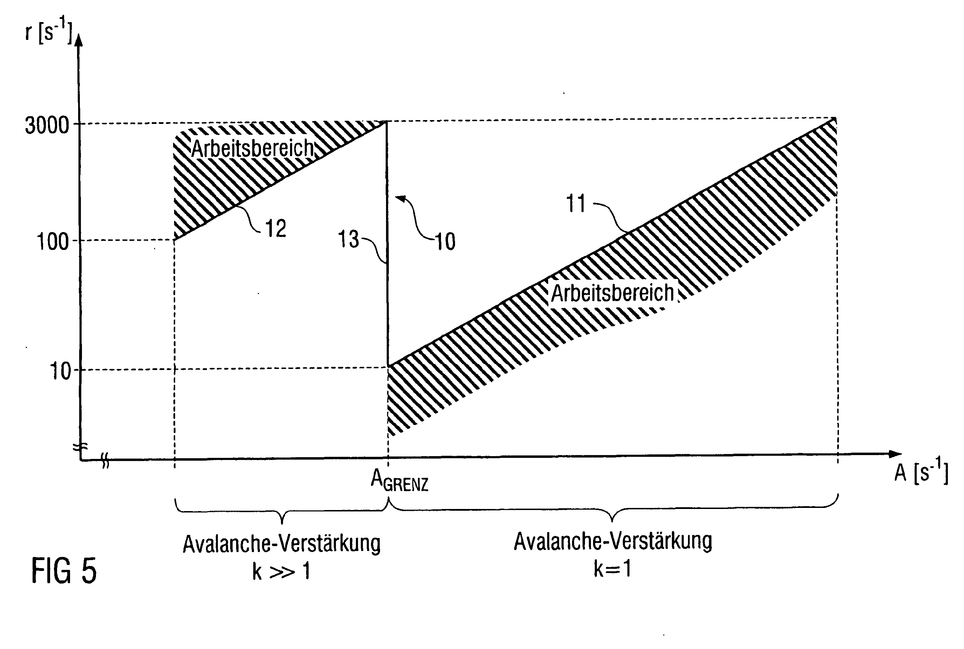

Darüber hinaus weist der erfindungsgemäße Strahlungsdetektor 1 eine einstellbare Bildwiederholrate r auf, wobei die Einstellung der Bildwiederholrate r und des Verstärkungsfaktors k der Avalanche-Verstärker 8 im Folgenden anhand von Figur 5 beschrieben wird. So zeigt Figur 5 eine sägezahnförmige Kennlinie 10, welche die Abhängigkeit der Bildwiederholrate r von der Intensität A der zu detektierenden Strahlung wiedergibt. Die Kennlinie 10 weist im Bereich einer großen Strahlungsintensität A eine steigende Flanke 11 und im Bereich einer geringen Strahlungsintensität A eine weitere steigende Flanke 12 auf, wobei die beiden Flanken 11, 12 durch eine senkrechte Flanke 13 miteinander verbunden sind.

Im Bereich der Flanke 11 der Kennlinie 10 ist die Intensität A der zu detektierenden Strahlung so groß, dass die Avalanche-Verstärker 8 abgeschaltet werden können und somit einen Verstärkungsfaktor von k=1 aufweisen, so dass in den Avalanche-Verstärkern 8 überhaupt keine optischen Photonen generiert werden, die zu einem unerwünschten Übersprechen führen.

Mit abnehmender Strahlungsintensität A muss dann jedoch die Bildwiederholrate r entsprechend dem Verlauf der Flanke 11 der Kennlinie 10 verringert werden, damit die Integrationszeiträume in den einzelnen Bildzellen 5 der CCD-Detektorstruktur 2 ausreichen, um genügend Signalelektronen zu generieren.

Wenn die Strahlungsintensität A jedoch einen vorgegebenen Grenzwert A_{GRENZ} unterschreitet, reicht die Verringerung der Bildwiederholrate r nicht mehr aus, um trotz der geringen Strahlungsintensität A noch genügend Signalelektronen in den Bildzellen 5 zu generieren. Bei einer Unterschreitung der Intensität A_{GRENZ} werden die Avalanche-Verstärker 8 deshalb angeschaltet und arbeiten mit einem Verstärkungsfaktor k»1, so dass die Bildwiederholrate r wieder angehoben werden kann. Bei weiter abnehmender Intensität A der zu detektierenden Strahlung kann dann auch die Bildwiederholrate r wieder entsprechend dem Verlauf der Flanke 12 der Kennlinie 10 abgesenkt werden.

In diesem Betriebsmodus wird jedes Photon detektiert. Es ist aber nicht nötig, mehrere Photonen in einer Bildzelle 5 zu sammeln, um über der elektrischen Rauschschwelle zu bleiben. Die Bildwiederholrate r wird so gewählt, dass die Wahrscheinlichkeit dafür, mehrere Photonen in derselben Bildzelle 5 zu sammeln, klein bleibt.

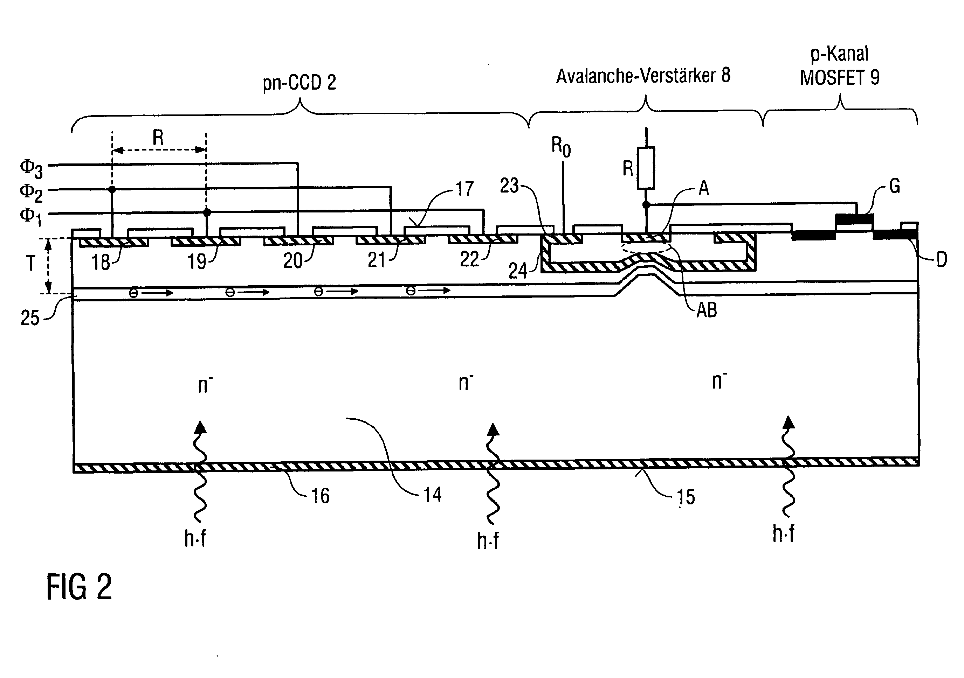

Im Folgenden wird nun anhand von Figur 2 der Aufbau des Strahlungsdetektors 1 beschrieben.

So weist der Strahlungsdetektor 1 ein schwach n-dotiertes Halbleitersubstrat 14 auf, wobei an einer Rückseite 15 des Halbleitersubstrats 14 eine p-dotierte Rückelektrode 16 angeordnet ist.

An einer Vorderseite 17 des Halbleitersubstrats 14 ist die CCD-Detektorstruktur 2 integriert, die in diesem Ausführungsbeispiel als pn-CCD-Detektorstruktur ausgeführt ist. Der Aufbau und die Funktionsweise der CCD-Detektorstruktur 2 ist beispielsweise in Gerhard Lutz: "Semiconductor radiation detectors", Springer Verlag, 2. Auflage 2001, Seite 137-152, beschrieben, so dass diesbezüglich auf diese Veröffentlichung verwiesen wird. An dieser Stelle ist lediglich zu erwähnen, dass die pn-CCD-Detektorstruktur mehrere Elektroden 18-22 aufweist, welche die in den einzelnen Bildzellen 5 der CCD-Detektorstruktur 2 generierten Signalelektronen in dem Halbleitersubstrat 14 in Pfeilrichtung in einer Tiefe T transportiert, die im Bereich von 0,25_{˙}R bis 0,5_{˙}R liegt, wobei R das Rastermaß der Elektroden 18-22 ist.

Weiterhin zeigt die Querschnittsansicht in Figur 2 den Aufbau des Avalanche-Verstärkers 8, der eine Ausleseelektrode A, eine Steuerelektrode 23 und einen vergrabenen, p-dotierten Halbleiterbereich 24 aufweist. Zwischen dem vergrabenen Halbleiterbereich 24 und der Ausleseelektrode A entsteht hierbei durch eine geeignete Ansteuerung der Steuerelektrode 23 in einem Avalanche-Bereich AB (Hochfeldbereich) eine elektrische Feldstärke, die ungefähr rechtwinklig zu der Vorderseite 17 des Halbleitersubstrats 14 ausgerichtet ist, und die von der CCD-Detektorstruktur 2 zugeführten Signalelektronen nach oben zu der Ausleseelektrode A beschleunigt, wobei die Feldstärke so eingestellt werden kann, dass eine Lawinenverstärkung in dem Avalanche-Verstärker 8 erfolgt. Hinsichtlich der Funktionsweise und des Aufbaus des Avalanche-Verstärkers 8 wird ergänzend auf die deutsche Patentanmeldung 10 2004 022 948.1-33 verwiesen, die einen Avalanche-Strahlungsdetektor betrifft, so dass der Inhalt dieser Patentanmeldung hinsichtlich des Aufbaus und der Funktionsweise des Avalanche-Verstärkers 8 der vorliegenden Beschreibung zuzurechnen ist.

Die Ausleseelektrode A des Avalanche-Verstärkers 8 ist mit einem Gate G des Transistor-verstärkers 9 verbunden, der in diesem Ausführungsbeispiel als p-Kanal-MOSFET ausgeführt ist und eine implantierte Source S und eine implantierte Drain D aufweist. Der Aufbau und die Funktionsweise eines p-Kanal-MOSFETs ist beispielsweise in Gerhard Lutz: "Semiconductor radiation detectors", Springer Verlag, 2. Auflage 2001, Seite 165-175, beschrieben, so dass der Inhalt dieser Veröffentlichung der vorliegenden Beschreibung hinsichtlich des Aufbaus und der Funktionsweise des Transistor-Verstärkers 9 zuzurechnen ist.

Schließlich ist in dem Halbleitersubstrat 14 noch ein n-dotierter, vergrabener Halbleiterbereich 25 angeordnet, der die Emission von Löchern zu der Rückelektrode 16 verhindern soll. Der Halbleiterbereich 25 kann gleichzeitig zur Führung der Signalelektronen dienen. Er muss auch nicht durchgehend verlaufen, sondern kann unterbrochen sein oder angehoben werden.

Der vergrabene Halbleiterbereich 25 ist unterhalb des Avalanche-Verstärkers 8 angehoben, wodurch die Signalelektronen in dem Avalanche-Bereich des Avalanche-Verstärkers 8 fokussiert werden.

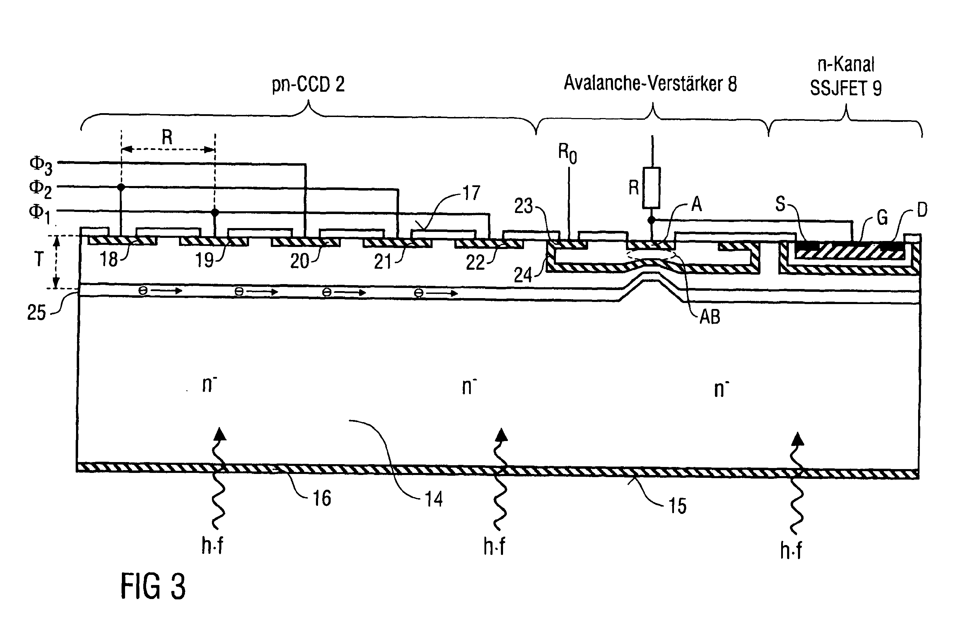

Figur 3 zeigt ein alternatives Ausführungsbeispiel, das weitgehend mit dem vorstehend beschriebenen und in Figur 2 dargestellten Ausführungsbeispiel übereinstimmt, so dass zur Vermeidung von Wiederholungen weitgehend auf die vorstehende Beschreibung zu Figur 2 verwiesen wird, wobei für entsprechende Elemente dieselben Bezugszeichen verwendet werden.

Eine Besonderheit dieses Ausführungsbeispiels besteht darin, dass der Transistor-Verstärker 9 hierbei als n-Kanal SSJFET (SSJFET - Single-Sided Junction Field Effect Transistor) ausgeführt ist. Der Aufbau und die Funktion des n-Kanal-SSJFET ist beispielsweise in Gerhard Lutz: "Semiconductor radiation detectors", Springer Verlag, 2. Auflage 2001, Seite 233-238, beschrieben, so dass der Inhalt dieser Veröffentlichung hinsichtlich des Aufbaus und der Funktionsweise des n-Kanal-SSJFET in vollem Umfang zuzurechnen ist.

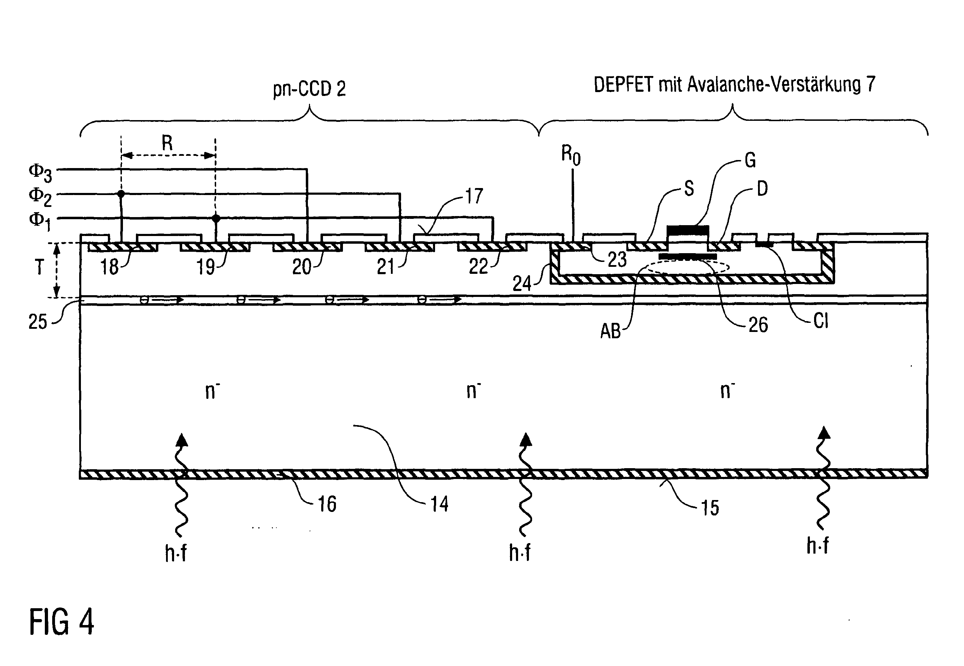

Schließlich zeigt Figur 4 ein weiteres Ausführungsbeispiel, das weitgehend mit dem vorstehend beschriebenen und in Figur 2 dargestellten Ausführungsbeispiel übereinstimmt, so dass zur Vermeidung von Wiederholungen auf die vorstehende Beschreibung verwiesen wird, wobei für entsprechende Elemente dieselben Bezugszeichen verwendet werden.

Eine Besonderheit besteht hierbei darin, dass der Avalanche-Verstärker 8 mit dem Transistor-Verstärker 9 räumlich integriert ist, wobei der Transistor-Verstärker 9 als DEPFET (DEPFET - Depletion Field Effect Transistor) ausgeführt ist. Der Aufbau und die Funktionsweise eines solchen DEPFET ist beispielsweise in Gerhard Lutz: "Semiconductor radiation detectors", Springer Verlag, 2. Auflage 2001, Seite 243-253, beschrieben, so dass der Inhalt dieser Veröffentlichung hinsichtlich des Aufbaus und der Funktionsweise des Transistor-Verstärkers 9 als DEPFET dieser Beschreibung in vollem Umfang zuzurechnen ist. An dieser Stelle ist lediglich zu erwähnen, dass der als DEPFET ausgebildete Transistor-Verstärker 9 ein Gate G, eine Source S, eine Drain D und einen Lösch-Kontakt Cl aufweist. Darüber hinaus weist der DEPFET unter dem Gate G einen vergrabenen, n-dotierten Halbleiterbereich 26 auf.

### Bezugszeichenliste:

- 1: Strahlungsdetektor
- 2: CCD-Detektorstruktur
- 3: Ausgangsverstärkereinheit
- 4: CAMEX-Verstärker
- 5: Bildzellen
- 6: Signalausgänge
- 7: Ausgangsverstärker
- 8: Avalanche-Verstärker
- 9: Transistor-Verstärker
- 10: Kennlinie
- 11, 12, 13: Flanken der Kennlinie
- 14: Halbleitersubstrat
- 15: Rückseite
- 16: Rückelektrode
- 17: Vorderseite
- 18-22: Elektroden
- 23: Steuerelektrode
- 24: Vergrabener Halbleiterbereich
- 25: Vergrabener Halbleiterbereich
- 26: Vergrabener Halbleiterbereich
- A: Ausleseelektrode
- AB: Avalanche-Bereich

## Patentansprüche

1. Strahlungsdetektor (1) zur Detektion intensitätsarmer Strahlung, insbesondere zur Detektion von Einzelphotonen, mit
a) mehreren Bildzellenreihen mit jeweils mehreren hintereinander angeordneten Bildzellen (5) und jeweils einem Signalausgang (6), wobei die zu detektierende Strahlung in den einzelnen Bildzellen (5) Signalladungsträger generiert, die entlang den Bildzellenreihen zu dem jeweiligen Signalausgang (6) transportiert werden, sowie mit
b) mehreren Ausgangsverstärkern (7), die parallel an jeweils einen der Signalausgänge der einzelnen Bildzellenreihen angeschlossen sind und die Signalladungsträger verstärken,
wobei
c) die Ausgangsverstärker (7) jeweils einen Avalanche-Verstärker (8) aufweisen, und **dadurch gekennzeichnet,**
d) **dass** die einzelnen Avalanche-Verstärker jeweils einen einzigen Avalanche-Bereich aufweisen, in dem die Avalanche-Verstärkung erfolgt, so dass die Avalanche-Verstärkung einstufig erfolgt.

2. Strahlungsdetektor (1) nach Anspruch 1, **dadurch gekennzeichnet, dass** die Bildzellen (5) und die Avalanche-Verstärker (8) gemeinsam in einem Halbleitersubstrat (14) integriert sind.

3. Strahlungsdetektor (1) nach einem der vorhergehenden Ansprüche, **dadurch gekennzeichnet, dass** die Ausgangsverstärker (7) zusätzlich zu den Avalanche-Verstärkern (8) jeweils einen Transistor-Verstärker (9) aufweisen.

4. Strahlungsdetektor (1) nach Anspruch 3, **dadurch gekennzeichnet, dass** der Transistor-Verstärker (9) einen Feldeffekttransistor aufweist.

5. Strahlungsdetektor (1) nach Anspruch 4, **dadurch gekennzeichnet, dass** der Feldeffekttransistor ein MOSFET oder ein JFET ist.

6. Strahlungsdetektor (1) nach einem der Ansprüche 3 bis 5, **dadurch gekennzeichnet, dass** die Transistor-Verstärker (9) den Avalanche-Verstärkern (8) nachgeschaltet sind.

7. Strahlungsdetektor (1) nach einem der Ansprüche 3 bis 6, **dadurch gekennzeichnet, dass** die Transistor-Verstärker (9) und die Avalanche-Verstärker (8) der einzelnen Ausgangsverstärker (7) zusammen mit den Bildzellen (5) auf einem Halbleitersubstrat (14) integriert sind.

8. Strahlungsdetektor (1) nach einem der vorhergehenden Ansprüche, **dadurch gekennzeichnet, dass** der Verstärkungsfaktor der Avalanche-Verstärker (8) maximal 500, 1000, 5000 oder 10000 beträgt.

9. Strahlungsdetektor (1) nach einem der vorhergehenden Ansprüche, **dadurch gekennzeichnet, dass** der Verstärkungsfaktor der Ausgangsverstärker (7) einstellbar ist.

10. Strahlungsdetektor (1) nach einem der vorhergehenden Ansprüche, **dadurch gekennzeichnet, dass** die Bildzellen (5) Bestandteil einer CCD-Detektorstruktur (2) sind.

11. Strahlungsdetektor (1) nach Anspruch 10, **dadurch gekennzeichnet, dass** die CCD-Detektorstruktur (2) eine pn-CCD-Detektorstruktur oder eine MOSCCD-Detektorstruktur ist.

12. Strahlungsdetektor (1) nach einem der vorhergehenden Ansprüche, **dadurch gekennzeichnet, dass** die Ausgangsverstärker (7) eine lineare Verstärkung aufweisen.

13. Strahlungsdetektor (1) nach einem der vorhergehenden Ansprüche, **dadurch gekennzeichnet, dass** die Bildzellen (5) matrixförmig in Zeilen und Spalten angeordnet sind.

14. Strahlungsdetektor (1) nach einem der vorhergehenden Ansprüche, **dadurch gekennzeichnet, dass** die Signalladungsträger Signalelektronen sind.

15. Strahlungsdetektor (1) nach einem der vorhergehenden Ansprüche, **dadurch gekennzeichnet, dass** die Ausgangsverstärker (7) an eine Auswertungseinheit angeschlossen sind, welche die detektierten Photonen zählt.

16. Betriebsverfahren für einen Strahlungsdetektor (1) mit den folgenden Schritten:
- Detektion von Photonen in mehreren Bildzellenreihen mit jeweils mehreren hintereinander angeordneten Bildzellen (5) und jeweils einem Signalausgang (6), wobei die zu detektierenden Photonen in den Bildzellen (5) Signalladungsträger generieren,
- Transportieren der generierten Signalladungsträger entlang den Bildzellenreihen zu dem Signalausgang (6),
- Verstärkung der an dem Signalausgang (6) erscheinenden Signalladungsträger,
wobei die Verstärkung der Signalladungsträger durch eine Avalanche-Verstärkung erfolgt, und **dadurch gekennzeichnet,**
- **dass** die Avalanche-Verstärkung in einem einzigen Avalanche-Bereich einstufig erfolgt.

17. Betriebsverfahren nach Anspruch 16, **dadurch gekennzeichnet, dass** die Avalanche-Verstärkung mit einem bestimmten Verstärkungsfaktor erfolgt, wobei der Verstärkungsfaktor in Abhängigkeit von Betriebsbedingungen des Strahlungsdetektors (1) eingestellt wird, wobei die Betriebsbedingungen den Photonenstrom der zu detektierenden Strahlung umfassen.

18. Betriebsverfahren nach Anspruch 16 oder 17, **dadurch gekennzeichnet, dass** die Detektion der Photonen mit einer bestimmten Bildwiederholrate (r) erfolgt, wobei die Bildwiederholrate (r) in Abhängigkeit von Betriebsbedingungen des Strahlungsdetektors (1) eingestellt wird, wobei die Betriebsbedingungen den Photonenstrom der zu detektierenden Strahlung umfassen.

19. Betriebsverfahren nach Anspruch 17 oder 18, **dadurch gekennzeichnet, dass** die Bildwiederholrate (r) entsprechend einer sägezahnförmigen Kennlinie (10) in Abhängigkeit von dem Photonenstrom eingestellt wird.

## Claims

1. A radiation detector (1) for detecting low-intensity radiation, in particular for detecting individual photons, comprising
a) a plurality of image cell rows, each having a plurality of image cells (5) arranged one behind the other, and a signal output (6), wherein the radiation to be detected generates signal charge carriers in the individual image cells (5) and said signal charge carriers are transported along the image cell rows to the respective signal output (6), and
b) a plurality of output amplifiers (7) which are connected in parallel, each to one of the signal outputs of the individual image cell rows, and amplify the signal charge carriers, wherein
c) the output amplifiers (7) each comprise an avalanche amplifier (8), and
**characterized in that**
d) the individual avalanche amplifiers each comprise a single avalanche region in which the avalanche amplification occurs so that the avalanche amplification occurs in a single stage.

2. The radiation detector (1) according to claim 1, **characterized in that** the image cells (5) and the avalanche amplifier (8) are together integrated into a semiconductor substrate (14).

3. The radiation detector (1) according to any one of the preceding claims, **characterized in that**, in addition to the avalanche amplifiers (8), the output amplifiers (7) each have a transistor amplifier (9).

4. The radiation detector (1) according to claim 3, **characterized in that** the transistor amplifier (9) has a field effect transistor.

5. The radiation detector (1) according to claim 4, **characterized in that** the field effect transistor is a MOSFET or a JFET.

6. The radiation detector (1) according to any one of the claims 3 to 5, **characterized in that** the transistor amplifiers (9) are connected downstream of the avalanche amplifiers (8).

7. The radiation detector (1) according to any one of the claims 3 to 6, **characterized in that** the transistor amplifiers (9) and the avalanche amplifiers (8) of the individual output amplifiers (7) are integrated, together with the image cells (5), on a semiconductor substrate (14).

8. The radiation detector (1) according to any one of the preceding claims, **characterized in that** the amplification factor of the avalanche amplifiers (8) amounts to a maximum of 500, 1000, 5000 or 10000.

9. The radiation detector (1) according to any one of the preceding claims, **characterized in that** the amplification factor of the output amplifiers (7) is adjustable.

10. The radiation detector (1) according to any one of the preceding claims, **characterized in that** the image cells (5) are a component part of a CCD detector structure (2).

11. The radiation detector (1) according to claim 15, **characterized in that** the CCD detector structure (2) is a pn-CCD detector structure or a MOSCCD detector structure.

12. The radiation detector (1) according to any one of the preceding claims, **characterized in that** the output amplifiers (7) have a linear amplification.

13. The radiation detector (1) according to any one of the preceding claims, **characterized in that** the image cells (5) are arranged in matrix form in rows and columns.

14. The radiation detector (1) according to any one of the preceding claims, **characterized in that** the signal charge carriers are signal electrons.

15. The radiation detector (1) according to any one of the preceding claims, **characterized in that** the output amplifiers (7) are connected to an evaluating unit which counts the detected photons.

16. An operating method for a radiation detector (1), comprising the following steps:
- detection of photons in a plurality of image cell rows, each having a plurality of image cells (5) arranged one behind the other and one signal output (6), wherein the photons to be detected generate signal charge carriers in the image cells (5),
- transporting of the generated signal charge carriers along the image cell rows to the signal output (6),
- amplification of the signal charge carriers appearing at the signal output (6), wherein
- the amplification of the signal charge carriers is carried out by means of avalanche amplification, and
**characterized in that**
- the avalanche amplification is made in a single stage in a single avalanche region.

17. An operating method according to claim 16, **characterized in that** the avalanche amplification is carried out with a particular amplification factor, wherein the amplification factor is adjusted depending on the operating conditions of the radiation detector (1), wherein the operating conditions comprise the photon flux of the radiation to be detected.

18. An operating method according to claim 16 or 17, **characterized in that** the detection of photons is carried out at a particular image refresh rate (r), wherein the image refresh rate (r) is adjusted depending on the operating conditions of the radiation detector (1), wherein the operating conditions comprise the photon flux of the radiation to be detected.

19. An operating method according to claim 17 or 18, **characterized in that** the image refresh rate (r) is adjusted according to a saw-tooth characteristic (10) depending on the photon flux.

## Revendications

1. Détecteur de rayonnement (1) pour la détection d'un rayonnement de faible intensité, en particulier pour la détection de photons simples, avec
a) plusieurs rangées de pixels comportant chacune plusieurs pixels (5) disposés les uns derrière les autres et une sortie de signal (6), le rayonnement à détecter générant des porteurs de signal dans les différents pixels (5), lesquels sont transportés le long des rangées de pixels vers la sortie de signal (6) correspondante, ainsi qu'avec
b) plusieurs amplificateurs de sortie (7) parallèlement raccordés chacun à une des sorties de signal des différentes rangées de pixels, et amplifiant les porteurs de signal,
où
c) les amplificateurs de sortie (7) comportant chacun un amplificateur d'avalanche (8),
et **caractérisé en ce que**
d) les différents amplificateurs d'avalanche comportent chacun une seule zone d'avalanche où est effectuée l'amplification d'avalanche, si bien que l'amplification d'avalanche est effectuée sur un seul étage.

2. Détecteur de rayonnement (1) selon la revendication 1, **caractérisé en ce que** les pixels () et les amplificateurs d'avalanche (8) sont intégrés ensemble à un substrat semi-conducteur (14).

3. Détecteur de rayonnement (1) selon l'une des revendications précédentes, **caractérisé en ce que** les amplificateurs de sortie (7) comportent chacun un amplificateur à transistor (9) en plus des amplificateurs d'avalanche (8).

4. Détecteur de rayonnement (1) selon la revendication 3, **caractérisé en ce que** l'amplificateur à transistor (9) comporte un transistor à effet de champ.

5. Détecteur de rayonnement (1) selon la revendication 4, **caractérisé en ce que** le transistor à effet de champ est un MOSFET ou un JFET.

6. Détecteur de rayonnement (1) selon l'une des revendications 3 à 5, **caractérisé en ce que** les amplificateurs à transistor (9) sont montés en aval des amplificateurs d'avalanche (8).

7. Détecteur de rayonnement (1) selon l'une des revendications 3 à 6, **caractérisé en ce que** les amplificateurs à transistor (9) et les amplificateurs d'avalanche (8) des différents amplificateurs de sortie (7) sont intégrés avec les pixels (5) à un substrat semi-conducteur (14).

8. Détecteur de rayonnement (1) selon l'une des revendications précédentes, **caractérisé en ce que** le facteur d'amplification des amplificateurs d'avalanche (8) est au maximum de 500, 1 000, 5 000 ou 10 000.

9. Détecteur de rayonnement (1) selon l'une des revendications précédentes, **caractérisé en ce que** le facteur d'amplification des amplificateurs de sortie (7) est réglable.

10. Détecteur de rayonnement (1) selon l'une des revendications précédentes, **caractérisé en ce que** les pixels (5) sont des éléments d'une structure de détecteur CCD (2).

11. Détecteur de rayonnement (1) selon la revendication 10, **caractérisé en ce que** la structure de détecteur CCD (2) est une structure de détecteur pn-CCD ou une structure de détecteur MOSCCD.

12. Détecteur de rayonnement (1) selon l'une des revendications précédentes, **caractérisé en ce que** les amplificateurs de sortie (7) présentent une amplification linéaire.

13. Détecteur de rayonnement (1) selon l'une des revendications précédentes, **caractérisé en ce que** les pixels (5) sont disposés matriciellement dans des rangées et des colonnes.

14. Détecteur de rayonnement (1) selon l'une des revendications précédentes, **caractérisé en ce que** les porteurs de signal sont des électrons de signal.

15. Détecteur de rayonnement (1) selon l'une des revendications précédentes, **caractérisé en ce que** les amplificateurs de sortie (7) sont raccordés à une unité d'évaluation qui compte les photons détectés.

16. Procédé de mise en service d'un détecteur de rayonnement (1), comportant les étapes suivantes :
- détection de photons dans plusieurs rangées de pixels comportant chacune plusieurs pixels (5) disposés les uns derrière les autres et une sortie de signal (6), les photons à détecter générant des porteurs de signal dans les pixels (5),
- transport des porteurs de signal générés le long des rangées de pixels vers la sortie de signal (6),
- amplification des porteurs de signal apparaissant à la sortie de signal (6),
où
- l'amplification des porteurs de signal est effectuée par une amplification d'avalanche, et **caractérisé en ce que**
l'amplification d'avalanche est effectuée sur un seul étage dans une seule zone d'avalanche.

17. Procédé de mise en service selon la revendication 16, **caractérisé en ce que** l'amplification d'avalanche est effectuée avec un facteur d'amplification défini, ledit facteur d'amplification étant réglé en fonction de conditions de service du détecteur de rayonnement (1), lesdites conditions de service comprenant le courant photonique du rayonnement à détecter.

18. Procédé de mise en service selon la revendication 16 ou la revendication 17, **caractérisé en ce que** la détection des photons est effectuée avec un taux de répétition d'image (r) défini, ledit taux de répétition d'image (r) étant réglé en fonction de conditions de service du détecteur de rayonnement (1), lesdites conditions de service comprenant le courant photonique du rayonnement à détecter.

19. Procédé de mise en service selon la revendication 17 ou la revendication 18, **caractérisé en ce que** le taux de répétition d'image (r) est réglé en fonction du courant photonique suivant une courbe caractéristique (10) en dents de scie.
